# EUROPÄISCHE PATENTSCHRIFT

(11) **EP 1 274 807 B1**
(45) Veröffentlichungstag und Bekanntmachung des Hinweises auf die Patenterteilung: **24.08.2005**
(21) Anmeldenummer: 01929438.8
(22) Anmeldetag: 19.03.2001
(51) Int. Cl.: C09G 1/02, C09K 3/14, H01L 21/3105

(54) **POLIERMITTEL UND VERFAHREN ZUR HERSTELLUNG PLANARER SCHICHTEN**
POLISHING AGENT AND METHOD FOR PRODUCING PLANAR LAYERS
AGENT DE POLISSAGE ET PROCEDE DE REALISATION DE COUCHES PLANAIRES

(30) Priorität: 31.03.2000 DE 10016020; 21.12.2000 DE 10063870
(43) Veröffentlichungstag der Anmeldung: 15.01.2003
(73) Patentinhaber: Bayer Aktiengesellschaft, 51368 Leverkusen (DE)
(72) Erfinder: VOGT, Kristina, 51061 Köln (DE); PANTKE, Dietrich, 40882 Ratingen (DE); PUPPE, Lothar, 51399 Burscheid (DE); KIRCHMEYER, Stephan, 51375 Leverkusen (DE)
(86) Internationale Anmeldenummer: PCT/EP2001/003113
(87) Internationale Veröffentlichungsnummer: WO 2001/074958

(56) Entgegenhaltungen:
- EP-A- 0 773 270
- US-A- 6 043 159

## Beschreibung

Die vorliegende Erfindung betrifft ein Poliermittel auf SiO₂-Basis und ein Verfahren zur Herstellung planarer Schichten.

Integrierte Halbleiterschaltungen (Integrated Circuits, IC) bestehen aus strukturierten halbleitenden, nichtleitenden und elektrisch leitfähigen dünnen Schichten. Diese strukturierten Schichten werden üblicherweise dadurch hergestellt, dass ein Schichtmaterial, z.B. durch Aufdampfen aufgebracht und durch ein mikrolithographisches Verfahren strukturiert wird. Durch die Kombination der verschiedenen halbleitenden, nicht leitenden und leitenden Schichtmaterialien werden die elektronischen Schaltungselcmente des IC, wie z.B. Transistoren, Kondensatoren, Widerstände und Verdrahtungen erzeugt.

Die Qualität eines IC und seine Funktion hängen in entscheidendem Maße von der Präzision ab, mit der die verschiedenen Schichtmaterialien aufgebracht und strukturiert werden können.

Mit steigender Schichtenanzahl nimmt jedoch die Planarität der Schichten deutlich ab. Dies führt ab einer bestimmten Schichtenanzahl zum Versagen einer oder mehrerer Funktionselemente des IC und damit zum Versagen des gesamten IC.

Die Verringerung der Planarität der Schichten ist Folge des Aufbaus neuer Schichten, wenn diese auf bereits strukturierte Schichten aufgebracht werden müssen. Durch die Strukturierung entstehen Höhenunterschiede, die bis zu 0,6 µm pro Schicht betragen können. Diese Höhenunterschiede addieren sich von Schicht zu Schicht und bewirken, dass die darauffolgende Schicht nicht mehr auf eine planare sondern auf eine unebene Fläche aufgebracht werden muss. Eine erste Folge ist, dass die nachfolgend aufgebrachte eine ungleichmäßige Dicke aufweist. In extremen Fällen entstehen so Fehlstellen, Defekte in den elektronischen Funktionselementen und mangelhafte Kontakte. Unebene Flächen führen zudem zu Problemen bei der Strukturierung. Um ausreichend kleine Strukturen erzeugen zu können, ist eine extrem hohe Abbildungsgenauigkeit (depth of focus, DOF) im mikrolithographischen Verfahrensschritt notwendig. Diese Strukturen können jedoch nur in einer Ebene scharf abgebildet werden; je stärker Stellen von dieser Ebene abweichen, desto unschärfer ist die Abbildung.

Zur Lösung dieses Problems wird ein sogenanntes chemisch-mechanisches Polieren (CMP) durchgeführt. Das CMP bewirkt eine globale Planarisierung der strukturierten Oberfläche durch Abtrag erhöhter Schichtteile, bis eine ebene Schicht erhalten wird. Hierdurch kann der nächstfolgende Schichtaufbau auf einer ebenen Fläche ohne Höhenunterschiede erfolgen und die Präzision der Strukturierung und die Funktionsfähigkcit der Elemente des IC bleiben erhalten.

Ein CMP-Schritt wird mit Hilfe von speziellen Poliermaschinen, Poliertüchern (Pads) und Poliermitteln (Polierslurries) durchgeführt. Eine Polierslurry ist eine Zusammensetzung, die in Kombination mit dem Poliertuch, dem sogenannten Pad, auf der Pollermaschine einen Abtrag des zu polierenden Materials bewirkt.

Eine Übersicht über die Technik des CMP ist z.B. in B. L. Mueller, J. S. Steckenrider Chemtech (1998) S. 38 - 46 beschrieben.

CMP-Slurries beeinflussen entscheidend das Polierverhalten während des Polierprozesses. Bislang wird davon ausgegangen, dass sowohl chemische als auch mechanische Vorgänge Einfluss nehmen. Aus diesem Grund werden spezifische Polierslurries für verschiedene Polierschritte benötigt.

Prinzipiell unterscheidet man zwischen dem Polieren von nichtleitenden Schichten, z.B. aus Siliziumdioxid, und dem Polieren von elektrisch leitfähigen Schichten, vorwiegend Metallen wie Wolfram, Aluminium und Kupfer. Das Polieren von Siliziumdioxid wird Oxid-CMP genannt.

In der Oxid-CMP gibt es darüber hinaus eine Reihe von verschiedenen Polierschritten, die sich durch die Aufgabe des Siliziumdioxids im jeweiligen Schichtaufbau und Anzahl und Art der am Schichtaufbau beteiligten Schichtinaterialien unterscheiden.

Ein wichtiger Schritt im Oxid-CMP-Prozess ist der sogenannte ILD-Polierschritt (interlayer dielectric), in dem das zwischen zwei Verdrahtungsebenen isolierende Siliziumdioxid poliert wird. Darüber hinaus nimmt aber die Bedeutung weiterer Oxid-CMP-Schritte zu, z.B. der sogenannte STI-Schritt (shallow trench isolation), in dem Isolierschichten von Halbleiterelementen poliert werden.

Insbesondere in Polierschritten, in denen Halbleiterschichten beteiligt sind, sind die Anforderungen an die Präzision des Polierschrittes und damit an die Polierslurry besonders groß.

Bewertungsmaßstab für die Wirksamkeit von Polierslurries sind eine Reihe von Größen, mit denen die Wirkung der Polierslurry charakterisiert wird. Hierzu gehören die Abtragsrate, d.h. die Geschwindigkeit mit der das zu polierende Material abgetragen wird, die Selektivität, d.h. das Verhältnis der Abtragsgeschwindigkeiten von zu polierendem Material zu anderen anwesenden Materialien, sowie Größen für die Gleichmäßigkeit der Planarisierung. Als Größen für die Gleichmäßigkeit der Planarisierung werden üblicherweise die Gleichmäßigkeit der Restschichtdicke innerhalb eines Wafers (WIWNU, within-wafer-non uniformity) und die Gleichmäßigkeit von Wafer zu Wafer (WTWNU, wafer-to wafer non uniformity) sowie die Anzahl der Defekte pro Flächeneinheit verwendet. Ein Wafer ist eine polierte Siliciumscheibe, auf der integrierte Schaltungen aufgebaut werden.

Als Polierslurries für Oxid-CMP werden stark alkalische Formulierungen von abrasiven Partikeln wie Aluminiumoxid, Siliziumdioxid und Ceroxid verwendet, wobei Polierslurries auf der Basis von Siliziumdioxid in der Praxis besondere Verbreitung gefunden haben.

Als Rohstoff zur Herstellung der Polierslurries dient in der Regel pyrogene Kieselsäure, die aus großen Aggregaten kleinerer Primärteilchen besteht, d.h. kleine meist kugelförmige Primärteilchen sind in der pyrogenen Kieselsäure fest zu größeren, unregelmäßig geformten Teilchen verbunden. Zur Herstellung einer Polierslurry ist es daher notwendig, diese Aggregate in möglichst kleine Teilchen zu zerteilen. Dies bewerkstelligt man durch Eintrag von Scherenergie, z.b. durch intensives Rühren, in Mischungen aus Wasser oder alkalischen Medien und pyrogener Kieselsäure. Durch die Schercnergie werden die Aggregate der pyrogenen Kieselsäure zerkleinert. Da jedoch die Effektivität des Eintrags der Scherenergie von der Teilchengröße abhängt, ist es nicht möglich, durch die Scherkräfte Teilchen von der Größe und der Form der Primärteilchen zu erzeugen. Die so hergestellten Polierslurries haben daher den Nachteil, dass die Zerkleinerung nicht vollständig erfolgt und Aggregate von Kieselsäure-Primärteilchen in der Slurry verbleiben. Dieser Grobpartikelanteil kann zu vermehrter Bildung von Kratzern und anderen unerwünschten Defekten auf der zu polierenden Oberfläche führen.

EP-A-899 005 lehrt, den Grobpartikelanteil durch Filtration zu vermeiden, jedoch ist dieses aufwendig und löst das Problem nur teilweise, da Aggregate unterhalb der Filtrationsgrenze verbleiben und aufgrund ihrer nichtkugeligen Form weiterhin die zu polierende Oberfläche schädigen können.

WO 96/027 2096, US-A-5 376 222 und EP-A-520 109 lehren die Verwendung von basischen Kieselsolen mit einem pH-Wert zwischen 9 und 12,5. Dieser pH-Wert wird durch Zusatz von Alkalihydroxid oder von Aminen eingestellt.

Diese Polierslurries weisen den Vorteil auf, dass sie praktisch ausschließlich aus diskreten kugelförmigen Teilchen bestehen, die nur in geringem Maße zu Kratzern und anderen Defekten auf der zu polierenden Oberfläche führen.

Der Nachteil dieser Polierslurries besteht in ihrer geringeren Abtragsrate. Diesen Nachteil versucht man mit vermehrtem Zusatz von basischen Polierbeschleunigem, d.h. Alkalihydroxid und Aminen zu kompensieren. Dem Zusatz von basischen Polierbeschleunigern sind jedoch bei Polierslurries auf der Basis von Siliziumdioxid aufgrund der chemischen Gleichgewichte für Siliziumdioxid Grenzen gesetzt. Ab einer bestimmten Menge von Hydroxidionen reagieren diese mit den Siliziumdioxid-Partikeln und lösen diese zu Silicaten auf (Peptisation). Daher sind Polierslurries mit einem pH von über 12 instabil und in der Technik nur schwer handhabbar.

In EP-A-874 036 und US-A-5 876 490 wird versucht, diese Problematik dadurch zu lösen, dass die Siliziumdioxid-Partikel mit Überzügen aus Polymeren bzw. Cerdioxid versehen werden. In JP 09/324 174 werden hierfür organische Polymere und Polysiloxane vorgeschlagen. In US-A-3 922 393 werden Überzüge aus Aluminiumoxid, in US-A-4 664 679 Oberflächenmodifizierungen zur Reduktion der Silanolgruppen an der Oberfläche beschrieben.

Hierdurch werden die Stabilitäten von Polierslurries auf der Basis von Siliziumdioxid-Partikeln erhöht. Jedoch wird nach bisherigem Wissen eine gewisse Menge an frei zugänglicher Siliziumdioxid-Oberfläche zur Erzielung ausreichender Abtragsraten benötigt. Auch wenn bislang noch nicht allzu viel über die an der Oberfläche ablaufenden chemischen Vorgänge bekannt ist, besteht die Vorstellung, dass diese Kugel-Oberflächen zur Ablagerung des von der zu polierenden Oberfläche entfernten Materials benötigt werden. Hierdurch weisen solche Polierslurries trotz erhöhter Mengen an Polierbeschleunigern unbefriedigende Polierraten auf. Zudem verteuert eine Oberflächenbehandlung der Poliermittel-Teilchen die Polierslurry und damit den Gesamtprozess der IC-Herstellung.

In Research Disclosure (RD) 419 020 wird beschrieben, dass in Abhängigkeit von der mittleren Partikelgröße die besten Polierergebnisse mit Kieselsol-Teilchen erhalten wurden, die eine mittlere Größe von 35 nm aufwiesen.

Es besteht jedoch weiterhin ein Bedarf an Polierslurries mit verbesserten Eigenschaften. Insbesondere werden für den STI-Schritt Polierslurries mit genügend hoher Abtragsrate, hoher Selektivität insbesondere zwischen Siliziumdioxid und Siliziumnitrid, guter Planarisierungswirkung und geringen Defektdichten gewünscht.

Diese Aufgabe wird überraschenderweise durch Bereitstellung von Poliermitteln auf Basis von Kieselsolen mit bimodaler Teilchengrößenverteilung gelöst.

Dies ist für den Fachmann überraschend, da aus RD 419 020 bekannt war, dass Kieselsol-Teilchen einer mittleren Teilchengröße von 35 nm optimale Poliereigenschaften aurweisen sollen.

Dies ist jedoch nicht der Fall. Die nun gefundenen Poliermittel weisen gegenüber Poliermitteln des Standes der Technik verbesserte Abtragsraten und erhöhte Selektivitäten auf.

Gegenstand der Erfindung sind daher Poliermittel enthaltend kugelförmige, diskrete, nicht über Bindungen miteinander verknüpfte Siliziumdioxid-Teilchen, dadurch gekennzeichnct, dass das Poliermittel
a) 5 bis 95 Gew.-%, vorzugsweise 20 bis 80 Gew.-%, Siliziumdioxid-Teilchen einer Größe von 5 bis 50 nm und
b) 95 bis 5 Gew.-%, vorzugsweise 80 bis 20 Gew.-%, Siliziumdioxid-Teilchen einer Größe von 50 bis 200 nm
enthält mit der Maßgabe, dass die Gesamtheit der Teilchen eine bimodale Teilchengrößenverteilung aufweist.

Gegenstand der Erfindung sind darüber hinaus Verfahren zur Herstellung planarer Schichten mit Hilfe dieser Poliermittel.

Die erfindungsgemäßen Poliermittel enthalten nicht über Bindungen miteinander verknüpfte Siliziumdioxid-Teilchen. Sie weisen Feststoff-Gehalte von 1 bis 60 Gew.-% auf, vorzugsweise 1 bis 30 Gew.-%, besonders bevorzugt 5 bis 20 Gew.-%, wobei es möglich ist, gewünschte Feststoff-Gehalte durch Zugabe von Wasser einzustellen. Die erfindungsgemäßen Pollermittel können neben Siliziumdioxid-Teilchen noch weitere Additive wie z.B. Polierbeschleuniger, oberflächenaktive Stoffe oder Verbindungen zur Viskositätseinstellung enthalten.

Basis der erfindungsgemäßen Poliermittel sind Kieselsole. Kieselsole enthalten nicht über Bindungen miteinander verknüpfte Siliziumdioxid-Teilchen. Kieselsole sind sedimentationsstabile, kolloidale Lösungen von amorphem SiO₂ in Wasser oder auch Alkoholen und anderen polaren Lösemitteln. Sie sind meistens wasserflüssig, und die Handelsprodukte haben z. T. hohe Feststoffkonzentrationen (bis zu 60 Gew.-%) und weisen eine große Stabilität gegen Gelierung auf.

Die Kieselsole sind milchig trüb über opaleszierend bis farblos klar je nach Teilchengröße der Siliziumdioxid-Partikel. Die Teilchen der Kieselsole haben Durchmesser von 5 nm bis 250 nm, vorzugsweise 5 nm bis 150 nm. Die Partikel sind kugelförmig, räumlich begrenzt und vorzugsweise elektrisch negativ geladen. Im Innern der einzelnen Partikel liegt üblicherweise ein Gerüst von Siloxan-Bindungen vor, das sich aus der Verknüpfung von [SiO₄]-Tetraedem bzw. von Polykieselsäuren ergibt. An der Oberfläche sind häufig SiOH-Gruppen angeordnet. Bevorzugt sind stabile Kieselsole mit spezifischen Oberflächen von ca. 30 bis 1000 m²/g. Die spezifischen Oberflächen können entweder nach der BET-Methode (s. S. Brunauer, P. H. Emmet und E. Teller, J. Am. Chem. Soc.,1938, 60, S. 309) an getrocknetem SiO₂-Pulver oder direkt in Lösung durch Titration nach G.W. Sears (s. Analytical Chemistry, Bd. 28, S. 1981, Jg. 1956) bestimmt werden.

Die verwendeten Kieselsole weisen üblicherweise eine Viskosität von weniger als 10 mPa·s bei einem Feststoffgehalt von 30 Gew.-% auf. Die Viskosität der Kieselsole hängt von der Teilchengröße, dem Gehalt von Elektrolyten, dem Siliziumdioxid-Gehalt und dem Vemetzungsgrad der Partikel ab. Bevorzugt sind die verwendeten Kieselsole unvernetzt und stabil gegen Gelierung.

Die Stabilität gegenüber irreversibler Gelierung zum Kieselgel, die auf einer räumlichen Vemetzung unter Ausbildung von Si-O-Si-Bindungen zwischen den Partikeln beruht, nimmt mit zunehmendem Siliziumdioxid-Gehalt, steigender Elektrolytverunreinigung und abnehmender Teilchengröße ab. Im allgemeinen lassen sich feinteilige Kieselsole (z.B. solche mit Teilchengrößen kleiner 6 nm) nur auf niedrigere Feststoff-Konzentrationen (z.B. < 30 Gew.-%) einstellen als grobteilige Kieselsole (mit z.B. Teilchengrößen größer als 50 nm) bei denen Feststoff-Gehalte bis zu 60 Gew.-% erreicht werden können.

Der pH-Wert der verwendeten Kieselsole liegt zwischen 1 und 12. Bevorzugt liegt der pH-Wert der verwendeten Kieselsole zwischen 9 und 11. Der Bereich zwischen pH 5 und pH 6 ist weniger bevorzugt, da Kieselsole in diesem Bereich nur eine geringe Stabilität aufweisen. Bei pH-Werten oberhalb von 12 tritt dann zunehmend Peptisierung und Auflösen der Teilchen unter Bildung von Alkalisilikat-Lösung ein.

Instabil sind Kieselsole gegenüber Elektrolytzusatz, wie z.B. Natriumchlorid, Ammoniumchlorid und Kaliumfluorid. Zur Stabilisierung enthalten Kieselsole Alkali, wie z.B. Natron- oder Kalilauge, Ammoniak oder andere Alkalien. Bevorzugt sind daher Kieselsole ohne Elektrolytzusatz.

Kieselsole können durch Kondensation von aus molekularen Silikatlösungen frisch hergestellten verdünnten Kieselsäurelösungen, seltener durch Peptisierung von Kieselgelen erhalten oder über andere Verfahren hergestellt werden. Der überwiegende Teil der im technischen Maßstab durchgeführten Verfahren zur Herstellung von Kieselsolen setzt als Ausgangsmaterial technische Wassergläser ein.

Geeignet für das Verfahren sind Natronwassergläser oder Kaliwassergläser, wobei aus Kostengründen Natronwassergläser bevorzugt sind. Handelsübliches Natronwasserglas hat eine Zusammensetzung von Na₂O 3,34 SiO₂ und wird üblicherweise durch Schmelzen von Quarzsand mit Soda oder einer Mischung aus Natriumsulfat und Kohle hergestellt, wobei man ein durchsichtiges farbloses Glas erhält, sog. Stückglas. Dieses Stückglas reagiert in gemahlener Form mit Wasser bei erhöhter Temperatur und Druck zu kolloidalen, stark alkalischen Lösungen, die anschließend noch einer Reinigung unterzogen werden.

Bekannt sind auch Verfahren, bei denen feinteiliger Quarz oder andere geeignete SiO₂-Rohstoffe unter hydrothermalen Bedingungen mit Alkalien direkt zu wässrigen Wassergläsern aufgeschlossen werden.

Zur Herstellung der in den Poliermitteln verwendeten Kieselsole ist eine Entfernung der ellkalikationen aus dem Wasserglas notwendig. Die gebräuchlichste Methode der Entalkalisierung ist die Behandlung von verdünnten Wasserglaslösungen mit Kationenaustauschern in der H⁺-Form. Vorzugsweise werden Wasserglaslösungen mit einem Siliziumdioxid-Gchalt unter 10 Gew.-% über Austauschersäulen geleitet. Wichtig sind kurze Verweilzeiten in der Austauschzone, in welcher der pH-Wert der Lösungen 5 bis 7 beträgt, um eine Gelierung der Lösungen und ein Verkieseln des Austauscherharzes zu vermeiden.

Die anfallende verdünnte Kieselsäurelösung (sog. Frischsol) ist sehr instabil und wird vorzugsweise sofort durch erneute Alkalisierung und durch thermische Behandlung stabilisiert und konzentriert. Besonders bevorzugt wird das Kieselsol stabilisiert, indem man die Lösung bis auf ein SiO₂ : Na₂O-Verhältnis von 60 bis 130 : 1 alkalisiert, einen Teil der Lösung zur Teilchenvergrößerung auf 60 bis 100°C erwärmt, und anschließend Frischsollösung kontinuierlich zugibt und auf die bereits vorhandenen Teilchen aufwachsen lässt. Gleichzeitig oder nachfolgend kann durch Eindampfen eine Aufkonzentrierung der Lösung auf die gewünschte Konzentration vorgenommen werden.

Durch genaue Reaktionsführung, pH-Kontrolle, Temperaturkontrolle oder durch eine gezielte Einstellung der Verweilzeiten kann ein gewünschtes Teilchengrößenspektrum eingestellt werden. Es ist ebenfalls möglich, zusätzlich zum Frischsol sogenannte Keimsole zuzusetzen. Als Keimsole können Kieselsole mit definierten Teilchengrößenverteilungen eingesetzt werden.

Es ist ebenfalls möglich, die verwendeten Kieselsole nach weiteren Verfahren herzustellen. Beispielsweise ist dies möglich durch Hydrolyse von Tetraethoxysilan (TEOS). Kieselsole, die nach diesem Verfahren erhalten werden, haben nur einen begrenzten Einsatz als Poliermittel in der Halbleiterfertigung aufgrund ihres hohen Preises.

Eine ausführliche Darstellung der Kieselsole findet sich in K.K. Iler, The Chemistry of Silica, Kapitel 4, S. 312-461, Wiley & Sons, New York, 1979.

Bevorzugt sind Kieselsole, die durch Entalkalisierung von Wassergläsern und anschließende Stabilisierung hergestellt werden und die eine bimodale Teilchengrößenverteilung aufweisen. Die Teilchengrößen der verwendeten Kieselsole liegen in einer Verteilung vor, die 5 - 95 Gew.-%, vorzugsweise 20 - 80 Gew.-% an Teilchen in einer Größenverteilung von 5 -50 nm und die 95-5 Gew.-%, vorzugsweise 80 - 20 Gew.-% an Teilchen in einer Größenverteilung von 50 bis 200 nm enthalten. Bimodal heißt, dass mindestens ein Minimum zwischen zwei Maxima bei der Teilchengrößenverteilung auftritt.

Für die Messung der Teilchengrößen im Nanometerbereich sind neben Elektronenmikroskopaufnahmen noch weitere verschiedene Methoden geeignet, wie z.B. Laserkorrelationsspektroskopie, Ultraschallmessungen oder Messungen mit einer Ultrazentrifuge. Die Ultrazentrifuge ist aufgrund ihrer hohen Trennschärfe besonders gut geeignet, bimodale Teilchengrößenverteilungen zu erkennen.

Das Besondere bei der Ultrazentrifuge besteht darin, dass vor der eigentlichen Messung eine Fraktionierung der Dispersion nach der Teilchengröße erfolgt. In einer homogenen Dispersion sedimentieren bekanntlich die großen Partikel schneller als die ebenfalls vorhandenen mittelgroßen und kleinen Partikel. Bei Durchstrahlung der Ultrazentrifugenzelle mit Laserlicht tritt in Abhängigkeit von der Zeit eine deutlich ausgeprägte Intensitätsänderung auf. Aus dieser Intensitätsänderung lässt sich die Konzentrationsänderung der Teilchen und hieraus die Teilchengrößenverteilung berechnen. Lichtquelle ist ein He-Ne-Laser. Die Ultrazentrifuge ermöglicht eine hohe Genauigkeit, ein hohes Auflösungsvermögen, und die Verteilungen sind exakt bestimmbar, was bei bimodalen Verteilungen besonders wichtig ist.

Die Herstellung bimodaler Kieselsole kann durch Mischen monomodaler Kieselsole erfolgen. Hierbei sind Mischungen mit unterschiedlichen Mengen an monomodalen Kieselsolen einstellbar, wobei eine Kieselsol-Komponente ein Teilchengrößenmaximum zwischen 5 und 50 nm und die zweite Kieselsol-Komponente ein Teilchengrößenmaximum zwischen 50 und 200 nm aufweist. Die Herstellung bimodaler Kieselsole kann ggf. auch während der Stabilisierung erfolgen. Bevorzugt ist die Herstellung bimodaler Kieselsole durch einen Mischungsprozess, da sich in diesem die gewünschten Mengenverhältnisse deutlich reproduzierbarer einstellen lassen. Die Formulierung des Sols zu einer Polierslurry erfolgt z.B. durch Verdünnen mit Wasser und der eventuellen Zugabe von Additiven. Additive können in Mengen von 0,01 Gew.-% bis 10 Gew.-%, bezogen auf die Polierslurry, zugesetzt werden.

Die Poliermittel-Kieselsole weisen pH-Werte von vorzugsweise 9 bis 12, besonders bevorzugt von 10 bis 11 auf. Die zur Polierbeschleunigung benötigten hohen pH-Werte können z.B. durch Zusatz von Alkalihydroxiden, wie z.B. Kalium- und Natriumhydroxid, Aminen oder Ammoniak bzw. Tetraalkylammoniumhydroxiden, eingestellt werden. Ebenfalls geeignet sind Salze, die bei der Hydrolyse alkalisch reagieren, wie z.B. Natriumcarbonat, Natriumhydrogencarbonat, Kaliumcarbonat, Kaliumhydrogencarbonat sowie Ammoniumhydrogencarbonat. Als Amine sind geeignet z.B. primäre Amine, sekundäre Amine, tertiäre Amine, heterocyclische Amine, Triamine, Tetramine oder Pentamine. Als Tetraalkylammoniumhydroxide können eingesetzt werden z.B. Tetramethylammoniumhydroxid, Tetraethylammoniumhydroxid, Tetrapropylammoniumhydroxid und Tetrabutylammoniumhydroxid.

Es können weitere Agenzien zur Verbesserung der Performance der Polierslurries zugesetzt werden: z.B. oberflächenaktive Stoffe, wie Alkylsulfate, Alkylsulfonate, Phenole, Glykole oder Fluortenside oder z.B. die Viskosität einstellende Stoffe wie Polyclektrolytc, Polyacrylsäuren, Polyethylenamine und Polysiloxane.

Oberflächenaktive Stoffe sind vorzugsweise anionische, kationische oder nichtionische niedermolekulare, oligomere oder polymere Emulgatoren, Tenside oder Schutzkolloide.

Beispiele von anionischen niedermolekularen, oligomeren bzw. polymeren Emulgatoren oder Tensiden sind Alkali- oder Erdalkalisalze von Fettsäuren, z.B. Natriumsalze von gesättigten Fettsäuren mit 10 bis 21 Kohlenstoffatomen, Natriumsalze von ungesättigten Fettsäuren mit 12 bis 18 Kohlenstoffatomen, Alkylethersulfonate wie Ethcr von Sulfo-hydroxy-polyethylenglykolen mit z.B. 1-Methylphenylethyl-phenol, Nonylphenol oder Alkylethem mit 12 bis 18 Kohlenstoffatomen, Aryl-alkyl-sulfonate wie beispielsweise mit geradkettigen oder verzweigten Butylgruppen versehene Naphthalinsulfonsäuren oder Alkylsulfate wie die Natriumsalze von langkettigen Schwefelsäurealkylestem.

Beispiele von kationischen niedermolekularen, oligomeren bzw. polymeren Emulgatoren oder Tensiden sind die Salze von langkettige Alkanreste tragenden Aminen mit 8 bis 22 Kohlenstoffatomen, die mit Säuren oder durch Alkylierung zu den Ammoniumverbindungen umgesetzt wurden sowie analoge Phosphor- und Schwefelverbindungen.

Beispiele nichtionischer ollgomerer bzw. polymerer Emulgatoren oder Tenside sind Alkylpolyglykolether oder -ester wie ethoxylierte gesättigte oder ungesättigte Bindungen tragende langkettige Alkohole z.B. mit 12 bis 18 Kohlenstoffatomen, ethoxyliertes Rizinusöl, ethoxylierte (Kokos)fettsäuren, ethoxyliertes Sojabotulenöl, ethoxylierte Resin- oder Rosinsäuren, ethoxylierter und gegebenenfalls propoxylierter Butyldiglykol, ethoxylierte Alkylarylether wie ethoxyliertes geradkettiges und/oder verzweigtes Nonylphenol oder Octylphenol oder benzyliertes p-Hydroxybiphenyl, ethoxylierte Tri- und Diglyceride und Alkylpolyglykoside.

Geeignet als Emulgatoren oder Tenside sind weiterhin ethoxylierte langkettige Alkyl- oder Alkenylamine, Lecithin, mit langkettigen Alkylisocyanaten modifizierte Umsetzungsprodukte aus Polyethylenglykolen und Diisocyanaten, Umsetzungsprodukte von Rapsöl- und Diethanolamin oder ethoxylierte Umsetzungsprodukte aus Sorbitan und langkettigen Alkan- oder Alkencarbonsäuren.

Geeignet sind zudem sogenannte Schutzkolloide, wie z.B. Polyvinylalkohole oder wasserlösliche Cellulosederivate wie Methylcellulose.

Im Nachfolgenden wird anhand von Beispielen die Erfindung erläutert, wobei sich das erfindungsgemäße Poliermittel nicht auf die genannten Beispiele beschränkt.

### Beispiele:

### Beispiel 1:

### Herstellung eines bimodalen Kieselsols

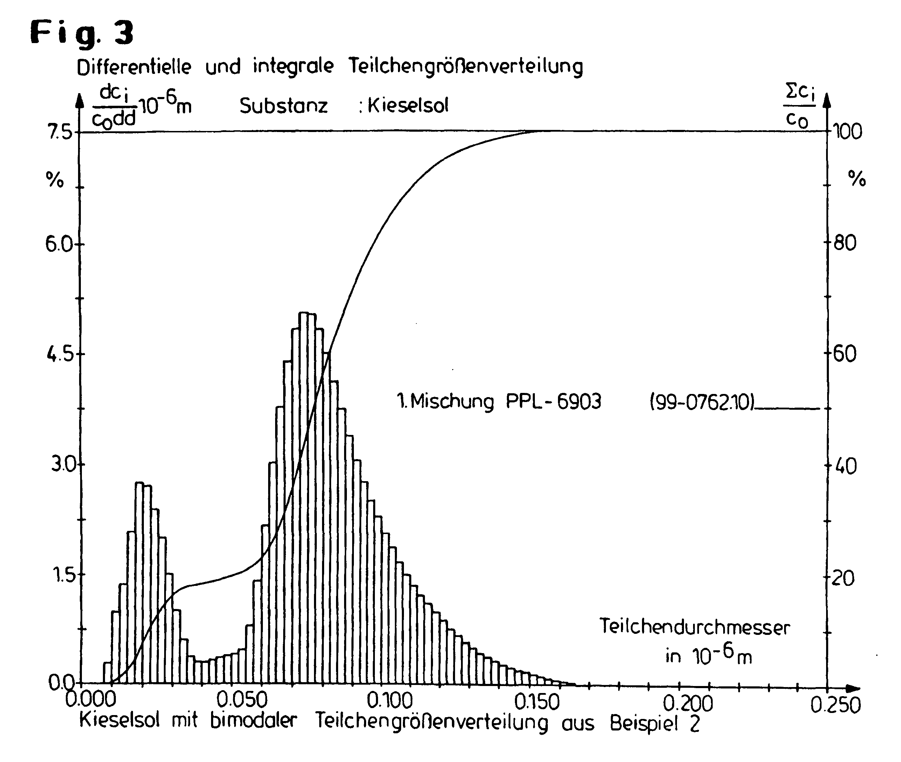

500 ml eines Kieselsol mit der mittleren Teilchengröße von 15 nm und einem pH-Wert von 9,3 werden bei Raumtemperatur mit 1583 ml eines Kieselsols mit einer mittleren Teilchengröße von 70 nm und einem pH-Wert von 9,4 gemischt. Die bimodale Teilchengrößenverteilung dieses Kieselsols ist aus der Abb. 3 ersichtlich. Dieses bimodale Kieselsol mit einem pH-Wert von 9,4 wird für den Polierversuch in Beispiel 2 eingesetzt.

### Beispiele 2 bis 4:

### Polierversuche

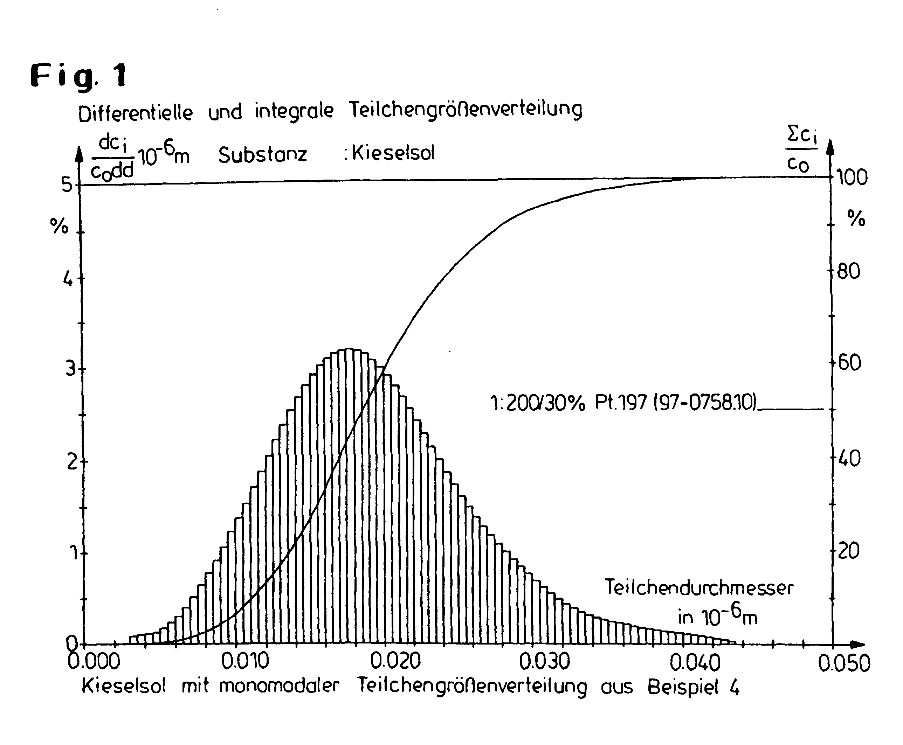

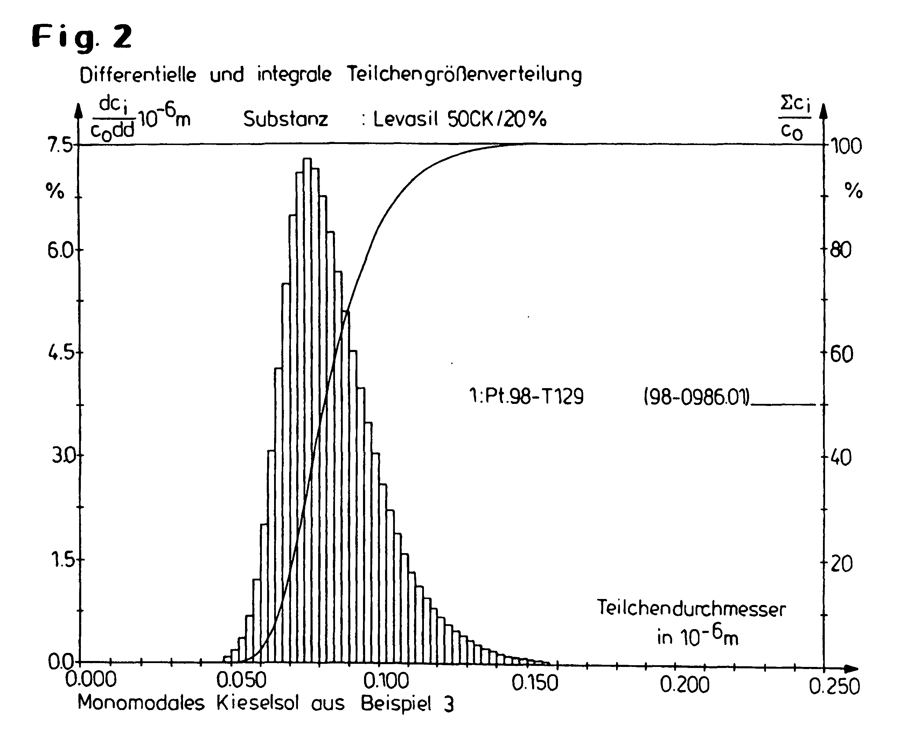

In der Tabelle sind die Beispiele 2 bis 4 mit den Abtragsraten und Selektivitäten der erfindungsgemäßen Kieselsole und der Vergleichskieselsole dargestellt. Die Polierbedingungen sind nachfolgend zusammengefasst. Im Beispiel 2 sind die Ergebnisse des Polierversuchs mit der Polierslurry mit dem erfindungsgemäßen bimodalen Kieselsol aus Beispiel 1 angegeben. Für die Polierslurry im Polierversuch 3 wird ein Kieselsol mit einer mittleren Teilchengröße von 70 nm (Abb.2) eingesetzt. Die Polierslurry im Polierversuch 4 enthält ein feinteiliges Kieselsol mit einer mittleren Teilchengrößenverteilung von 15 nm (Abb.1).

### Polierbedingungen für die Versuche

### Poliermaschine: IPEC 472

| | |
|---|---|
| Anpressdruck | 0,5 bar |
| Gegendruck | 0 bar |
| Tellergeschwindigkeit | 32 Upm |
| Trägergeschwindigkeit | 28 Upm |
| Dosiergeschwindigkeit der Polierslurry | 175 ml/ min |
| Polierzeit | 1 min |
| Poliertuch | Rodel IC 1400 |

Eingesetzt werden unstruk-turierte (blanket) Wafer mit 200 mm Durchmesser. Die Dicke der Oxidschicht (TEOS) beträgt 10000 Angström und die Dicke der Nitridschicht beträgt 6000 Angström.

Die Abtragsrate für das Oxid (TEOS) wird in Angström pro Minute angegeben, die Selektivität gibt das Verhältnis der Abtragsrate des Oxids zum Siliciumnitrid an.

**Tabelle:**

| Abtragsraten und Selektivität von kieselsolhaltigen Polierslurries | | |
|---|---|---|
| Polierslurry | Abtragsrate [Angström/min] | Selektivität Oxid/Nitrid |
| **Beispiel 2** | | |
| Bimodales Kieselsol Teilchengrößenverteilung (Abb. 3) | 3051 | 8,0 |
| | | |

| **Vergleichsbeispiel 3** | | |
|---|---|---|
| Monomodales Kieselsol Teilchengrößenverteilung (Abb. 2) | 2857 | 6,6 |
| | | |

| **Vergleichsbeispiel 4** | | |
|---|---|---|
| Monomodales Kieselsol Teilchengrößenverteilung (Abb. 1) | 2109 | 4,0 |

Wie aus den Versuchsergebnissen der Tabelle ersichtlich ist, weist die Polierslurry mit dem erfindungsgemäßen bimodalen Kieselsol aus Beispiel 1 eine deutlich höhere Abtragsrate und eine verbesserte Selektivität auf als die beiden Polierslurries der Vergleichsbeispiele mit jeweils monomodalen Kieselsolen.

## Patentansprüche

1. Poliermittel enthaltend kugelförmige, diskrete, nicht über Bindungen miteinander verknüpfte Siliziumdioxid-Teilchen, **dadurch gekennzeichnet, dass** das Poliermittel
a) 5 bis 95 Gew.-% Siliziumdioxid-Teilchen einer Größe von 5 bis 50 nm und
b) 95 bis 5 Gew.-% Siliziumdioxid-Teilchen einer Größe von 50 bis 200 nm
enthält mit der Maßgabe, dass die Gesamtheit der Teilchen eine bimodale Teilchengrößenverteilung aufweist.

2. Poliermittel gemäß Anspruch 1, **dadurch gekennzeichnet, dass** das Poliermittel
a) 20 bis 80 Gew.-% Siliziumdioxid-Teilchen einer Größe von 5 bis 50 nm und
b) 80 bis 20 Gew.-% Siliziumdioxid-Teilchen einer Größe von 50 bis 200 nm
enthält.

3. Poliermittel gemäß Anspruch 1 und 2, **dadurch gekennzeichnet, dass** das Poliermittel einen pH-Wert von 9 bis 12 aufweist.

4. Poliermittel gemäß Anspruch 1 bis 3, **dadurch gekennzeichnet, dass** das Poliermittel einen Feststoff-Gehalt von 1 bis 60 Gew.-% aufweist.

5. Poliermittel gemäß Anspruch 1 bis 4, **dadurch gekennzeichnet, dass** das Poliermittel durch Mischen von monomodalen Kieselsolen mit unterschiedlichen Teilchengrößen erhalten worden ist.

6. Poliermittel gemäß Anspruch 1 bis 5, **dadurch gekennzeichnet, dass** das Poliermittel eine Selektivität von 6 bis 15 aufweist.

7. Verfahren zur Herstellung planarer Oxid-Schichten, **dadurch gekennzeichnet, dass** ein Poliermittel gemäß Anspruch 1 bis 5 verwendet wird.

## Claims

1. Polishing abrasive containing spherical, discrete silica particles which are not linked to one another via bonds, **characterized in that** the polishing abrasive contains
a) 5 to 95% by weight silica particles of a size from 5 to 50 nm, and
b) 95 to 5% by weight silica particles of a size from 50 to 200 nm
with the proviso that the total set of particles has a bimodal particle size distribution.

2. Polishing abrasive according to Claim 1, **characterized in that** the polishing abrasive contains
a) 20 to 80% by weight silica particles of a size of from 5 to 50 nm, and
b) 80 to 20% by weight silica particles of a size of from 50 to 200 nm.

3. Polishing abrasive according to Claims 1 and 2, **characterized in that** the polishing abrasive has a pH of from 9 to 12.

4. Polishing abrasive according to Claims 1 to 3, **characterized in that** the polishing abrasive has a solids content from 1 to 60% by weight.

5. Polishing abrasive according to Claims 1 to 4, **characterized in that** the polishing abrasive has been obtained by mixing monomodal silica sols with different particle sizes.

6. Polishing abrasive according to Claims 1 to 5, **characterized in that** the polishing abrasive has a selectivity of from 6 to 15.

7. Process for producing planar oxide layers, **characterized in that** a polishing abrasive according to Claims 1 to 5 is used.

## Revendications

1. Agent de polissage qui contient des particules de dioxyde de silicium sphériques distinctes non reliées les unes aux autres par des liaisons, **caractérisé en ce que** l'agent de polissage contient :
a) de 5 à 95 % en poids de particules de dioxyde de silicium d'une taille de 5 à 50 nm et
b) de 95 à 5 % en poids de particules de dioxyde de silicium d'une taille de 50 à 200 nm,
avec la condition que la teneur totale en particules présente une répartition granulométrique bimodale.

2. Agent de polissage selon la revendication 1, **caractérisé en ce que** l'agent de polissage contient :
a) de 20 à 80 % en poids de particules de dioxyde de silicium d'une taille de 5 à 50 nm et
b) de 80 à 20 % en poids de particules de dioxyde de silicium d'une taille de 50 à 200 nm.

3. Agent de polissage selon les revendications 1 et 2, **caractérisé en ce que** l'agent de polissage présente un pH dont la valeur est comprise entre 9 et 12.

4. Agent de polissage selon les revendications 1 à 3, **caractérisé en ce que** l'agent de polissage présente une teneur en solides de 1 à 60 % en poids.

5. Agent de polissage selon les revendications 1 à 4, **caractérisé en ce que** l'agent de polissage est obtenu par mélange de sols de silice monomodaux qui présentent différentes granulométries.

6. Agent de polissage selon les revendications 1 à 5, **caractérisé en ce que** l'agent de polissage présente une sélectivité de 6 à 15.

7. Procédé de fabrication de couches planes d'oxyde, **caractérisé en ce que** l'on utilise un agent de polissage selon les revendications 1 à 5.
